# EUROPEAN PATENT APPLICATION

(11) **EP 4 528 791 A1**
(43) Date of publication of application: **26.03.2025**
(21) Application number: 24200252.5
(22) Date of filing: 13.09.2024
(51) Int. Cl.: H01L 21/308, H01L 21/02, H01L 21/67

(54) **SUBSTRATE TREATMENT METHOD AND SUBSTRATE TREATMENT APPARATUS**

(30) Priority: 22.09.2023 JP 2023156686
(71) Applicant: SCREEN Holdings Co., Ltd., Kyoto-shi, Kyoto 602-8585 (JP)
(72) Inventor: Tanaka, Yuji, Kyoto, 602-8585 (JP); Masahiko, Harumoto, Kyoto, 602-8585 (JP)
(74) Representative: Kilian Kilian & Partner mbB

(57) **Abstract**

A pretreatment solution is supplied to an upper surface of a peripheral edge part of a substrate on which a pattern is formed to form a liquid film of the pretreatment solution, and subsequently, a coating solution is supplied on the liquid film to form a coating film. The pretreatment solution is a solution including a solvent of the coating solution or a solution reducing a contact angle of the coating solution with respect to an upper surface of the substrate. When the liquid film of the pretreatment solution is formed, the pretreatment solution reaches and recoats the upper surface of the peripheral edge part of the substrate several times while the substrate is rotated with a relatively large number of rotations, thus the liquid film of the pretreatment solution having a uniform width is formed. The liquid film of the pretreatment solution and the coating solution are extremely compatible with each other, thus when the coating solution is supplied on the liquid film of the pretreatment solution having a uniform width, the coating solution extends to the same region as the liquid film, and the coating film having a uniform width can be formed.

## Description

### BACKGROUND OF THE INVENTION

### Field of the Invention

The present invention relates to a substrate treatment method of forming a coating film on a peripheral edge part of a disk-shaped substrate and a substrate treatment apparatus. Examples of a substrate to be treated include a semiconductor wafer, a substrate for a liquid crystal display device, a substrate for a flat panel display (FPD), a substrate for an optical disk, a substrate for a magnetic disk, or a substrate for a solar cell.

### Description of the Background Art

In photolithography as an important technique for forming a pattern in a process of manufacturing a semiconductor device, a development treatment is performed after a resist film is formed on a substrate of a semiconductor wafer, for example, and a pattern exposure is performed on the resist film. When a transfer arm or a positioning part, for example, has contact with an end edge part of a substrate with a resist film on a whole surface thereof, a defect occurs in the resist film to cause dust, and there is a possibility that the transfer arm, for example, is contaminated by the dust. Thus, a solvent is supplied to a peripheral edge part of the substrate to remove the resist film on the peripheral edge part. Accordingly, a silicon base material is exposed in the peripheral edge part of the substrate.

For example, when a deep reactive ion etching (DRIE) process is executed using a resist film on which a pattern is formed, a damage occurs in the peripheral edge part of the substrate where the base material is exposed. Then, strength of the peripheral edge part of the substrate decreases, and particles may occur. Thus, Japanese Patent Application Laid-Open Nos. 7-130703 and 2002-334879 disclose a technique of forming a protection film for preventing etching on a peripheral edge part of the substrate.

In order to form the protection film on the peripheral edge part of the substrate, a coating solution is typically supplied to an upper surface of the peripheral edge part from a nozzle, and is then dried to form the coating film. A width of the coating film is preferably uniform over a whole peripheral edge part of the substrate. However, uniformity of the width of the coating film may be reduced by various factors such as a vibration of a nozzle in supplying the coating solution, variation of a discharge state of the coating solution, or eccentricity of the substrate itself.

### SUMMARY

The present invention is directed to a substrate treatment method of forming a coating film on a peripheral edge part of a disk-shaped substrate.

According to one aspect of the present invention, a substrate treatment method includes steps of: (a) supplying a pretreatment solution including a solvent of a coating solution for forming the coating film to the substrate while rotating the substrate in a horizontal plane, and forming a liquid film of the pretreatment solution in an annular application region having a same width as a target width in forming the coating film in an upper surface of the peripheral edge part of the substrate; and (b) supplying the coating solution on the liquid film of the pretreatment solution while rotating the substrate in a horizontal plane, and forming the coating film.

The coating solution extends to the same region as the liquid film of the pretreatment solution, thus the coating film having a uniform width can be formed.

According to another aspect of the present invention, a substrate treatment method includes steps of: (a) supplying a pretreatment solution reducing a contact angle of a coating solution for forming the coating film with respect to an upper surface of the substrate to the substrate while rotating the substrate in a horizontal plane, and forming a liquid film of the pretreatment solution in an annular application region having a same width as a target width in forming the coating film in the upper surface of the peripheral edge part of the substrate; and (b) supplying the coating solution on the liquid film of the pretreatment solution while rotating the substrate in a horizontal plane, and forming the coating film.

The coating solution extends to the same region as the liquid film of the pretreatment solution, thus the coating film having a uniform width can be formed.

It is preferable that in the (a), the pretreatment solution is supplied to a lower surface of the peripheral edge part of the substrate so that the pretreatment solution extends from an end edge part to the upper surface of the peripheral edge part of the substrate.

A width of the liquid film of the pretreatment solution can be uniformized.

It is preferable that in the (a), the pretreatment solution is supplied to the upper surface of the peripheral edge part of the substrate while the substrate is rotated 500 times or more per minute to make the pretreatment solution reach and recoat the application region several times.

A width of the liquid film of the pretreatment solution can be uniformized.

The present invention is also directed to a substrate treatment apparatus forming a coating film on a peripheral edge part of a disk-shaped substrate.

According to one aspect of the present invention, a substrate treatment apparatus includes: a rotation holding part rotating the substrate around a central axis of the substrate while holding the substrate in a horizontal posture; a pretreatment solution discharge nozzle supplying a pretreatment solution including a solvent of a coating solution for forming the coating film to the substrate which is rotated, and forming a liquid film of the pretreatment solution in an annular application region having a same width as a target width in forming the coating film in an upper surface of the peripheral edge part of the substrate; and a coating solution discharge nozzle supplying the coating solution on the liquid film of the pretreatment solution formed on the upper surface of the peripheral edge part of the substrate which is rotated, and forming the coating film.

The coating solution extends to the same region as the liquid film of the pretreatment solution, thus the coating film having a uniform width can be formed.

According to another aspect of the present invention, a substrate treatment apparatus includes: a rotation holding part rotating the substrate around a central axis of the substrate while holding the substrate in a horizontal posture; a pretreatment solution discharge nozzle supplying a pretreatment solution reducing a contact angle of a coating solution for forming the coating film with respect to an upper surface of the substrate to the substrate which is rotated, and forming a liquid film of the pretreatment solution in an annular application region having a same width as a target width in forming the coating film in the upper surface of the peripheral edge part of the substrate; and a coating solution discharge nozzle supplying the coating solution on the liquid film of the pretreatment solution formed on the upper surface of the peripheral edge part of the substrate which is rotated, and forming the coating film.

The coating solution extends to the same region as the liquid film of the pretreatment solution, thus the coating film having a uniform width can be formed.

It is preferable that the treatment solution discharge nozzle supplies the pretreatment solution to a lower surface of the peripheral edge part of the substrate to make the treatment solution extend from an end edge part to the upper surface of the peripheral edge part of the substrate.

A width of the liquid film of the pretreatment solution can be uniformized.

It is preferable that the treatment solution discharge nozzle supplies the pretreatment solution to the upper surface of the peripheral edge part of the substrate while the rotation holding part rotates the substrate 500 times or more per minute to make the pretreatment solution reach and recoat the application region several times.

A width of the liquid film of the pretreatment solution can be uniformized.

Accordingly, an object of the present invention is to form a coating film with a uniform width.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a diagram illustrating a schematic configuration of a substrate treatment apparatus according to the present invention.
Fig. 2 is a flow chart illustrating a procedure of a treatment operation in the substrate treatment apparatus in Fig. 1.
Fig. 3 is a diagram schematically illustrating formation of a liquid film of a pretreatment solution.
Fig. 4 is a diagram schematically illustrating adjustment of a film thickness of the liquid film of the pretreatment solution.
Fig. 5 is a plan view of a substrate on which the liquid film of the pretreatment solution is formed.
Fig. 6 is a diagram schematically illustrating formation of a coating film.
Fig. 7 is a diagram schematically illustrating drying of the coating film.
Fig. 8 is a diagram schematically illustrating cleaning of a back surface of the substrate.
Fig. 9 is a diagram illustrating a schematic configuration of a main part of the substrate treatment apparatus according to a second embodiment.
Fig. 10 is a diagram schematically illustrating formation of a liquid film of a pretreatment solution according to the second embodiment.

### DESCRIPTION OF THE PREFERRED EMBODIMENTS

Embodiments according to the present invention will now be described in detail with reference to the drawings. In the description hereinafter, unless otherwise noted, the expressions indicating relative or absolute positional relationships (e.g., "in one direction", "along one direction", "parallel", "orthogonal", "central", "concentric", and "coaxial") include those exactly indicating the positional relationships and those where an angle or a distance is relatively changed within tolerance or to the extent that similar functions can be obtained. Unless otherwise noted, the expressions indicating equality (e.g., "same", "equal", and "uniform") include those indicating quantitatively exact equality and those in the presence of a difference within tolerance or to the extent that similar functions can be obtained. Unless otherwise noted, the expressions indicating shapes (e.g., "circular", "rectangular", and "cylindrical") include those indicating geometrically exact shapes and those indicating, for example, roughness or a chamfer to the extent that similar effect can be obtained. An expression "comprising", "including", or "having" a certain constituent element is not an exclusive expression for excluding the presence of the other constituent elements. An expression "at least one of A, B, and C" involves "only A", "only B", "only C", "arbitrary two of A, B, and C", and "all of A, B, and C".

### <First embodiment>

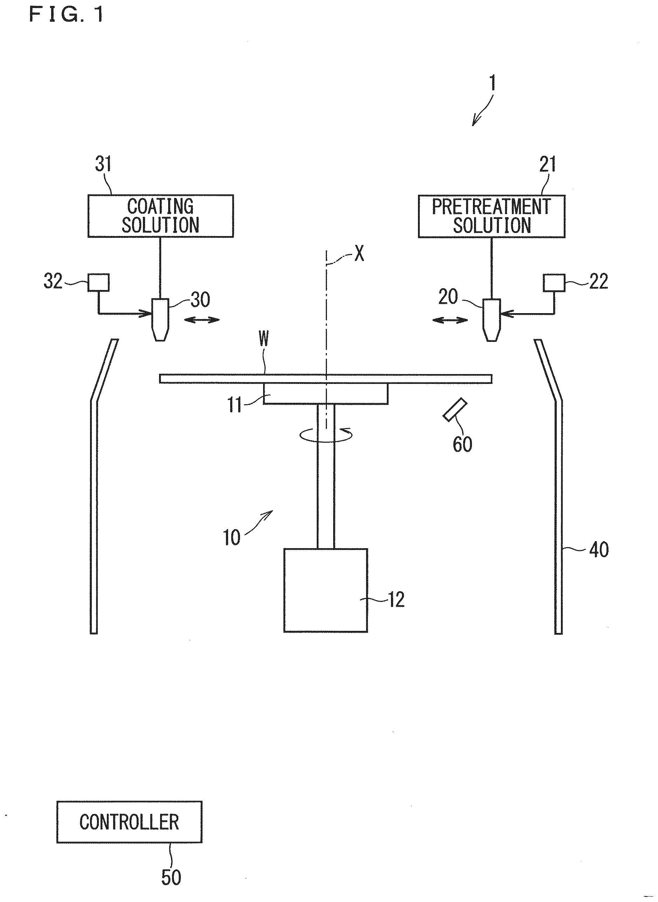

Fig. 1 is a diagram illustrating a schematic configuration of a substrate treatment apparatus 1 according to the present invention. The substrate treatment apparatus 1 in Fig. 1 is a coating apparatus (spin coater) supplying a predetermined coating solution to a peripheral edge part of a disk-shaped substrate W while rotating the substrate W and forming a coating film. The substrate W to be treated is a silicon semiconductor wafer, for example. A size of the semiconductor wafer is not particularly limited, but has a diameter of 300 mm or 450 mm, for example (300 mm in the present embodiment).

The substrate treatment apparatus 1 includes a rotation holding part 10, a first nozzle 20, and a second nozzle 30 as main elements. The substrate treatment apparatus 1 includes a controller 50 controlling various operating mechanisms provided inside the substrate treatment apparatus 1 and proceeding with a treatment on the substrate W.

The rotation holding part 10 includes a spin chuck 11 and a spin motor 12. The spin chuck 11 is a substrate holding part holding the substrate W in a horizontal posture (posture in which a normal line of a main surface of the substrate W follows a vertical direction). The spin chuck 11 is a vacuum suction chuck, for example. The spin chuck 11 has a disk-like shape with a diameter smaller than the substrate W. The spin chuck 11 sucks and holds a center part of a lower surface of the substrate W. In a state where the lower surface of the substrate W is sucked and held by the spin chuck 11, the peripheral edge part of the substrate W protrudes to an outer side of an outer surrounding end of the spin chuck 11. The spin chuck 11 may be a chuck in the other form such as a sandwiching-type mechanical chuck.

The spin chuck 11 is connected to the spin motor 12 via a motor shaft. That is to say, an upper end of the motor shaft of the spin motor 12 is connected to a center part of the lower surface of the spin chuck 11. When the spin motor 12 rotates the motor shaft while the substrate W is sucked and held by the spin chuck 11, the substrate W and the spin chuck 11 are rotated in a horizontal plane around a central axis X of the substrate W along a vertical direction.

A cup 40 is provided to surround the spin chuck 11. The cup 40 can go up and down by an elevating mechanism not illustrated in the diagrams. The cup 40 has a cylindrical shape, and an upper part of the cup 40 is inclined to get closer to the spin chuck 11 toward an upper side. However, an inner diameter of an upper end part of the cup 40 is larger than the diameter of the substrate W. In treatment of the substrate W, the upper end of the cup 40 is located in a higher position than a height position of the substrate W held by the spin chuck 11. Accordingly, a liquid flying in all directions from the substrate W rotated by the spin motor 12 by centrifugal force is received by the cup 40 and collected. The liquid collected by the cup 40 is discharged from a discharge solution pipe provided to a bottom part of the cup 40. The cup 40 may have a multi-stage structure that a plurality of collection ports are provided for various purposes.

The first nozzle 20 is a pretreatment solution discharge nozzle discharging a pretreatment solution to the substrate W held by the spin chuck 11. In the first embodiment, the first nozzle 20 is disposed on an upper side of the substrate W held by the spin chuck 11. The first nozzle 20 is connected to a pretreatment solution supply part 21 via a pipe. The pretreatment solution supply part 21 feeds the pretreatment solution to the first nozzle 20. Although described in detail hereinafter, the pretreatment solution is a liquid including propylene glycol monomethyl ether acetate (PGMEA) or propylene glycol monomethyl ether (PGME), for example.

The first nozzle 20 can reciprocate between an upper side of a center of the substrate W held by the spin chuck 11 and an upper side of the peripheral edge part thereof by a first nozzle drive mechanism 22 conceptually illustrated in Fig. 1. The first nozzle drive mechanism 22 may be a mechanism moving the first nozzle 20 along an arc-shaped trajectory (mechanism pivoting a nozzle arm) or a mechanism linearly moving the first nozzle 20 along a radial direction of the substrate W (linear drive mechanism). The first nozzle drive mechanism 22 can also move the first nozzle 20 to a waiting position on an outer side of the cup 40.

In the meanwhile, the second nozzle 30 is a coating solution discharge nozzle discharging a coating solution to the substrate W held by the spin chuck 11. The second nozzle 30 is connected to a coating solution supply part 31 via a pipe. The coating solution supply part 31 feeds the coating solution to the second nozzle 30. The coating solution of the present embodiment is a treatment solution forming a coating film functioning as a protection film having resistance to an etching treatment such as DRIE when being dried, and a solution for forming the photoresist or a bottom layer film, for example, is used. Exemplified as a solution for forming the bottom layer film is a spin-on-glass (SOG) solution including a silicon-containing polymer or a spin-on-carbon (SOC) solution including a carbon-containing polymer, for example.

The second nozzle 30 can reciprocate between the upper side of the center of the substrate W held by the spin chuck 11 and the upper side of the peripheral edge part thereof by a second nozzle drive mechanism 32 conceptually illustrated in Fig. 1. In the manner similar to the first nozzle drive mechanism 22, the second nozzle drive mechanism 32 may be a mechanism moving the second nozzle 30 along an arc-shaped trajectory or a mechanism linearly moving the second nozzle 30 along the radial direction of the substrate W. The second nozzle drive mechanism 32 can also move the second nozzle 30 to a waiting position on an outer side of the cup 40.

The substrate treatment apparatus 1 includes a back rinse nozzle 60. The back rinse nozzle 60 is disposed and fixed to a lower side of the substrate W held by the spin chuck 11. The back rinse nozzle 60 is provided to be inclined so that a discharge direction is directed to obliquely upper side from a center side of the substrate W toward an end edge part side thereof. The back rinse nozzle 60 discharges a liquid including PGMEA or PGME, or cyclohexane, for example, as a rinse solution.

The controller 50 controls various operating mechanisms provided to the substrate treatment apparatus 1. The controller 50 is similar in hardware configuration to a typical computer. Specifically, the controller 50 includes a CPU that is a circuit for performing various computation processes, a ROM or read-only memory for storing a basic program therein, a RAM or readable/writable memory for storing various pieces of information therein, and a storage part (magnetic disk or SSD) for storing control software, data and the like therein. When a CPU of the controller 50 executes a predetermined treatment program to control operations of the rotation holding part 10, the first nozzle 20, and the second nozzle 30, the treatment of the substrate W in the substrate treatment apparatus 1 proceeds.

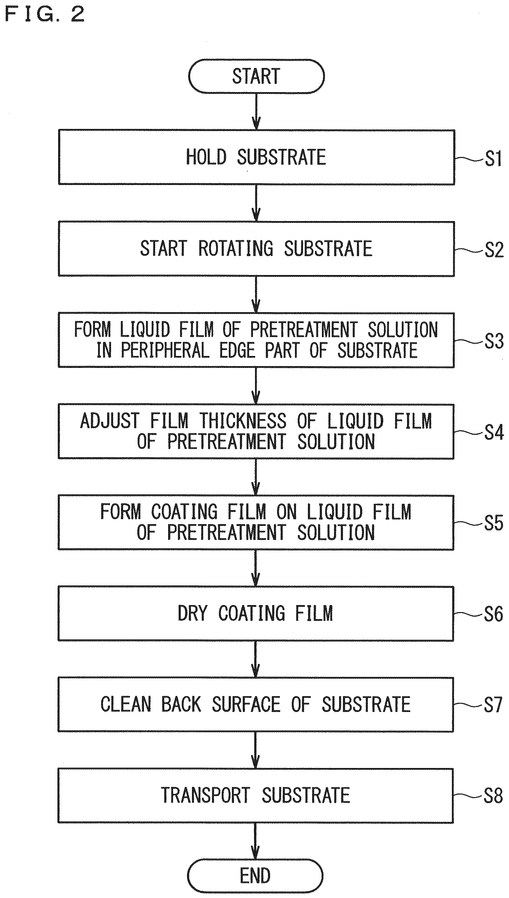

A treatment operation in the substrate treatment apparatus 1 is described next. Fig. 2 is a flow chart illustrating a procedure of the treatment operation in the substrate treatment apparatus 1. Before the substrate W is transported into the substrate treatment apparatus 1, a resist film is formed on the substrate W by a coating-developing apparatus (coater-developer) provided separately from the substrate treatment apparatus 1, and a development treatment is performed on the resist film on which a pattern exposure is performed to form a pattern. The resist film is removed from the peripheral edge part of the substrate W immediately after the formation of the resist film to prevent occurrence of dust caused by contact of the end edge part of the substrate W where the resist film is formed with the transfer arm or the positioning part. Accordingly, a silicon base material is exposed in the peripheral edge part of the substrate W.

The substrate W where the pattern formation is performed and the resist film is removed from the peripheral edge part is transported into the substrate treatment apparatus 1 by a transfer robot not illustrated in the diagrams, and is held by the rotation holding part 10 (Step S1). The spin chuck 11 of the rotation holding part 10 sucks the center part of the lower surface of the substrate W and holds the substrate W in the horizontal posture.

Next, the rotation of the substrate W held by the rotation holding part 10 in the horizontal posture is started (Step S2). The spin motor 12 of the rotation holding part 10 rotates the substrate W around the central axis X of the substrate W in a horizontal plane.

When the number of rotations of the substrate W reaches a predetermined number, a pretreatment solution is supplied to the peripheral edge part of the substrate W from the first nozzle 20 to form a liquid film (Step S3). In the present embodiment, the first nozzle 20 supplies a liquid including PGMEA or PGME, for example, as the pretreatment solution. The peripheral edge part of substrate W is a region on an outer side (end edge part side) of the region where the pattern is formed, and more specifically, a region within 3 mm from the end edge part toward the center side of the substrate W.

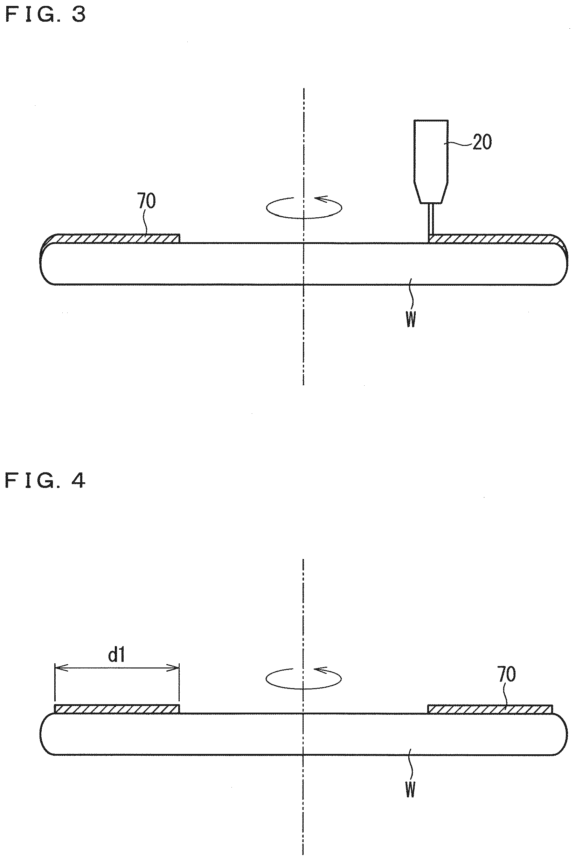

Fig. 3 is a diagram schematically illustrating formation of the liquid film of the pretreatment solution. More specifically, the first nozzle 20 firstly moves from an outer side toward the center part of the rotated substrate W while discharging the pretreatment solution toward a lower side, and stops on immediately an upper side of a predetermined position in the upper surface of the substrate W. The predetermined position is a position defined as the coating film formed in a subsequent process on a most center side of the substrate. The predetermined position is exaggeratingly illustrated in Fig. 3 for the sake of easier understanding, but is an appropriate position ranging from 1 mm to 3 mm from the end edge part toward the center part of the substrate W.

The first nozzle 20 supplies the pretreatment solution for a certain period of time on immediately the upper side of the predetermined position, and then moves toward the outer side of the substrate W. The pretreatment solution supplied from the first nozzle 20 flows to extend to an outer side (end edge part side) of the predetermined position described above on the upper surface of the substrate W by centrifugal force according to the rotation of the substrate W. Accordingly, a liquid film 70 of the pretreatment solution is annularly formed in the peripheral edge part of the upper surface of the substrate W on a side closer to the end edge part in relation to the predetermined position described above. The predetermined position described above is located an innermost side (center side of the substrate) of an area where the coating film is to be formed, thus the liquid film 70 of the pretreatment solution is formed in an annular application region having the same width as a target width in forming the coating film in the upper surface of the peripheral edge part of the substrate W.

An appropriate value can be applied to the number of rotations of the substrate W when the pretreatment solution is supplied from the first nozzle 20 to form the liquid film 70. As the number of rotations of the substrate W increases, the pretreatment solution flies away from the substrate W by the centrifugal force, and the film thickness of the liquid film 70 decreases. In contrast, as the number of rotations of the substrate W decreases, the film thickness of the liquid film 70 increases. In the first embodiment, the number of rotations of the substrate W is 500 rpm or more which is relatively large for the process of forming the liquid film. Even when the substrate W is rotated with considerably a large number of rotations, the pretreatment solution does not completely fly away from the substrate W, but the liquid film 70 is formed as long as the pretreatment solution is continuously supplied from the first nozzle 20 and continuously reaches the upper surface of the substrate W.

Furthermore, the substrate W is rotated more than once while the pretreatment solution is supplied to the peripheral edge part of the substrate W from the first nozzle 20. That is to say, the pretreatment solution reaches and recoat the application region described above on the upper surface of the peripheral edge part of the substrate W several times (recoating).

Subsequently, the controller 50 controls the number of rotations and a rotation time of the substrate W, for example, to adjust the film thickness of the liquid film 70 of the pretreatment solution (Step S4). Fig. 4 is a diagram schematically illustrating adjustment of the film thickness of the liquid film 70 of the pretreatment solution. Specifically, the controller 50 controls the operation of the spin motor 12 so that the number of rotations and the rotation time of the substrate W have preset values. The film thickness of the liquid film 70 of the pretreatment solution is evenly reduced by the adjustment of the film thickness in Step S4. The liquid film 70 of the pretreatment film is dried to some extent by the rotation of the substrate W in Step S4, but is not completely dried. That is to say, the liquid film 70 of the pretreatment solution maintains a liquid-phase state.

The liquid film 70 of the pretreatment solution with a width d1 is formed on the upper surface of the peripheral edge part of the substrate W by the processes of Step S3 and Step S4. The width d1 of the liquid film 70 of the pretreatment solution is the same as the target value of the coating film to be formed in the subsequent process. The film thickness of the liquid film 70 of the pretreatment solution formed on the upper surface of the peripheral edge part of the substrate W is adjusted to have an appropriate value by the number of rotations of the substrate W in Step S4. In the first embodiment, the number of rotations of the substrate W is relatively large in Step S3, and the film thickness of the liquid film 70 of the pretreatment solution is correspondingly small, thus the process of adjusting the film thickness in Step S4 may be omitted.

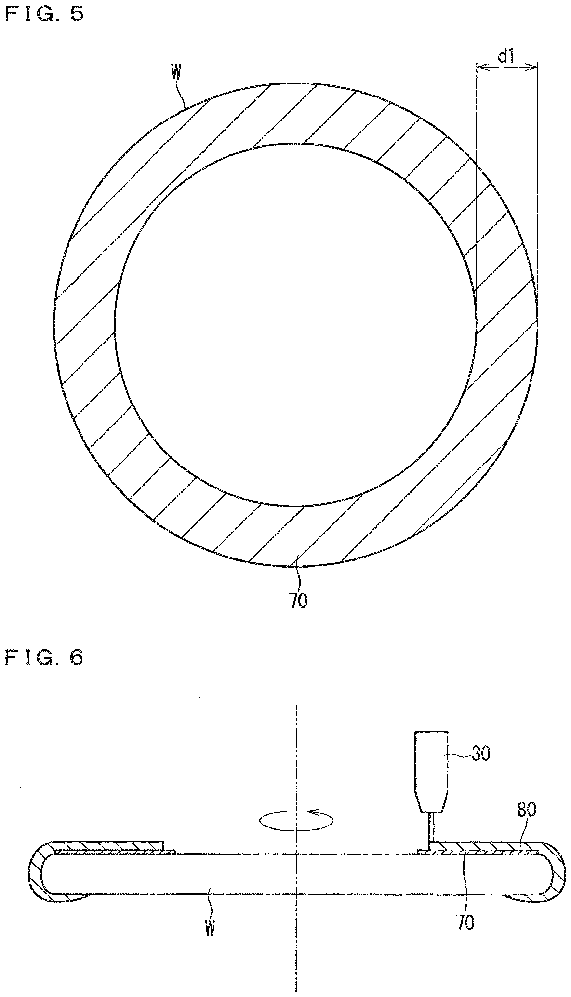

Fig. 5 is a plan view of the substrate W on which the liquid film 70 of the pretreatment solution is formed. The pretreatment solution is supplied to the upper surface of the peripheral edge part of the substrate W from the first nozzle 20 while the substrate W is rotated at a relatively larger number of rotations of 500 times or more per minute to make the pretreatment solution reach and recoat the application region several times, thus the liquid film 70 of the pretreatment solution having the uniform width d1 is annularly formed on the upper surface of the peripheral edge part of the substrate W. That is to say, the pretreatment solution recoats the substrate W while the substrate W is rotated with a large number of rotations, thus the width of the liquid film 70 of the pretreatment solution is uniformized. The width of the liquid film 70 of the pretreatment solution is a length of the liquid film 70 along the radial direction of the substrate W, and the same applies to a width of a coating film 80 described hereinafter.

Next, the coating solution is supplied from the second nozzle 30 to form the coating film on the liquid film 70 of the pretreatment solution (Step S5). In the present embodiment, the second nozzle 30 supplies a solution for forming the photoresist or the bottom layer film as the coating solution.

Fig. 6 is a diagram schematically illustrating formation of the coating film. More specifically, the second nozzle 30 firstly moves from an outer side toward the center part of the rotated substrate W while discharging the pretreatment solution toward a lower side, and stops on immediately an upper side of a predetermined position in the upper surface of the substrate W. The predetermined position at this time is the same position as that of an end portion of the liquid film 70 of the pretreatment solution on a center side of the substrate or a position on slightly an outer side (end edge part side) thereof. The second nozzle 30 supplies the coating solution for a certain period of time on immediately the upper side of the predetermined position, and then moves toward the outer side of the substrate W. The second nozzle 30 supplies the coating solution on the liquid film 70 of the pretreatment solution only during a period in which the substrate W is rotated once. That is to say, the coating solution is applied only once on the liquid film 70 on the upper surface of the peripheral edge part of the substrate W (one coating). The coating solution supplied from the second nozzle 30 flows and extends on the liquid film 70 of the pretreatment solution by centrifugal force according to the rotation of the substrate W. Accordingly, the coating film 80 is annularly formed on the liquid film 70 of the pretreatment solution. The coating solution supplied from the second nozzle 30 partially extends from the end edge part to the peripheral edge part of the lower surface of the substrate W.

In the first embodiment, the pretreatment solution of the liquid film 70 formed as a base film of the coating film 80 is a liquid including PGMEA or PGME. PGMEA and PGME are also used as a solvent of a coating solution for forming the coating film 80. Accordingly, the liquid film 70 of the pretreatment solution and the coating solution are extremely compatible with each other, thus the coating solution supplied on the liquid film 70 of the pretreatment solution resultingly has high wettability, and a contact angle of the coating solution with respect to the upper surface of the substrate decreases. That is to say, the pretreatment solution is also a liquid reducing the contact angle of the coating solution with respect to the upper surface of the substrate. When the coating solution is supplied to the liquid film 70 of such a pretreatment solution, the coating solution extends to melt into the liquid film 70 of the pretreatment solution. As a result, the coating solution extends to the same annular region as the liquid film 70 of the pretreatment solution, and the width of the coating film 80 is equal to the width d1 of the liquid film 70 of the pretreatment solution previously formed as the base layer.

The coating solution is supplied on the liquid film 70 of the pretreatment solution, thus an effect of easily forming the coating film 80 itself is also obtained. Specifically, change is provided to a surface state of the peripheral edge part of the substrate W in some preprocesses in some cases, and a shape of level difference may be formed, for example. Even when the shape of level difference is provided to the peripheral edge part of the substrate W, influence of thereof is reduced by forming the liquid film 70 of the pretreatment solution on the upper surface of the peripheral edge part, and the coating film 80 can be easily formed.

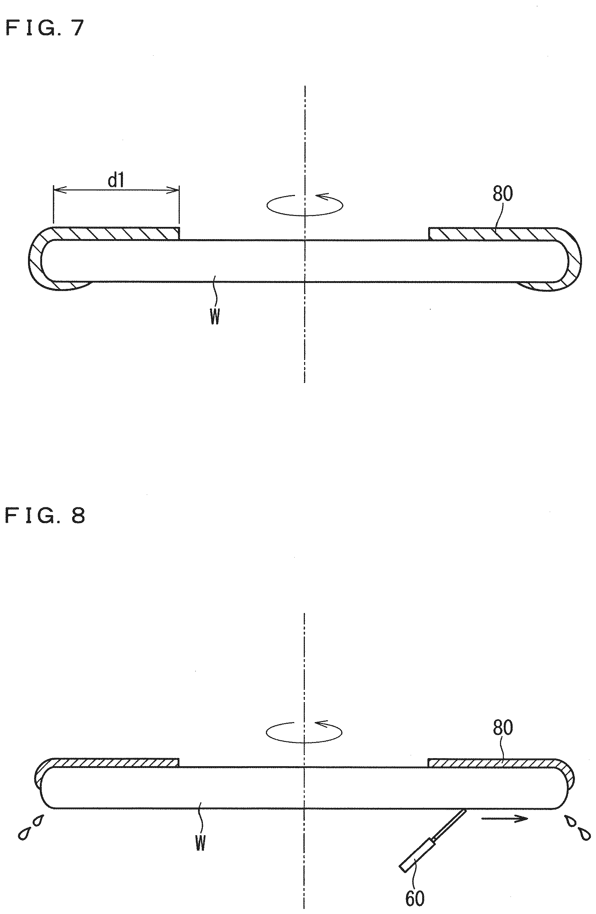

Next, the coating film 80 formed in the peripheral edge part of the substrate W is dried (Step S6). Fig. 7 is a diagram schematically illustrating drying of the coating film 80. Specifically, the controller 50 controls the operation of the spin motor 12 so that the number of rotations of the substrate W significantly gets large. A so-called spin drying is executed when the substrate W is rotated at a high speed, and the coating film 80 is dried. Fig. 6 clearly illustrates an interface between the liquid film 70 of the pretreatment solution and the coating film 80 for the sake of easier understanding, however, the pretreatment solution is also the solvent of the coating film as described above, thus when the coating solution is supplied on the liquid film 70 of the pretreatment solution, they are immediately mixed and integrated with each other. As a result, as illustrated in Fig. 7, the annular coating film 80 having a single layer is formed on the upper surface of the peripheral edge part of the substrate W in a drying process in Step S6.

The coating film 80 having the width d1 is formed on the upper surface of the peripheral edge part of the substrate W by the processes of Step S5 and Step S6. The width d1 of the coating film 80 is the same as the width of the liquid film 70 of the pretreatment solution formed in the processes of Step S3 and Step S4. The liquid film 70 of the pretreatment solution is formed so that the width thereof is the same as the target width of the coating film 80. Thus, the width of the coating film 80 which has been formed coincides with the target width.

After the drying process, a back surface of the substrate W is cleaned (Step S7). Fig. 8 is a diagram schematically illustrating cleaning of the back surface of the substrate W. The coating solution partially extends from the end edge part to the peripheral edge part of the lower surface of the substrate W when the coating solution is supplied to the peripheral edge part of the rotated substrate W in Step S5. The coating solution extending to the lower surface of the substrate W is dried in the drying process in Step S6, and is firmly attached to the lower surface thereof as the coating film. In Step S7, such a coating film firmly attached to the lower surface of the substrate W is rinsed away. Specifically, a rinse solution is discharged from the back rinse nozzle 60 to the lower surface of the substrate W while rotating the substrate W. The rinse solution supplied to the lower surface of the substrate W flows to the end edge part side along the lower surface of the substrate W by centrifugal force. The coating film firmly attached to the lower surface of the substrate W is rinsed away by the flow of the rinse solution, and is removed.

Subsequently, the substrate W on which the coating film 80 is formed is transported from the substrate treatment apparatus 1 by a transfer robot not illustrated in the diagrams (Step S8). A DRIE process, for example, is performed as a post-process on the substrate W transported from the substrate treatment apparatus 1. In the DRIE process, the coating film 80 protects the upper surface of the peripheral edge part of the substrate W.

When the coating film 80 is directly formed on the upper surface of the substrate W without forming the liquid film 70 of the pretreatment solution, uniformity of the width of the coating film 80 is often deteriorated by some factors described hereinafter. Firstly, when vibration occurs in the second nozzle 30 itself in discharging the coating solution from the second nozzle 30, the coating solution discharged from the second nozzle 30 also vibrates, and the width of the coating film 80 is not uniform. Secondly, the width of the coating film 80 is not uniform also when a discharge state of the coating solution discharged from the second nozzle 30 varies. Thirdly, the second nozzle 30 supplies the coating solution on the liquid film 70 of the pretreatment solution only during a period in which the substrate W is rotated once, and the width of the coating film 80 is often discontinuous at a position where the supply of the coating solution is started. Fourthly, a notch (orientation flat in a wafer having a diameter of 200 mm) for indicating a crystal orientation is formed in the substrate W as a disk-shaped semiconductor wafer, and the width of the coating film 80 is not uniform at the notch part. Furthermore, fifthly, when a center of the substrate W is eccentric from a rotation axis of the spin motor 12, the uniformity of the width of the coating film 80 is deteriorated by influence of the eccentricity.

In the first embodiment, the pretreatment solution is firstly supplied to the upper surface of the peripheral edge part of the substrate W to form the liquid film 70 of the pretreatment solution, and then the coating solution is supplied on the liquid film 70 to form the coating film 80. When the liquid film 70 of the pretreatment solution is formed, the pretreatment solution reaches and recoats the upper surface of the peripheral edge part of the substrate W several times while the substrate W is rotated 500 times or more per minute, thus the liquid film 70 of the pretreatment solution having the uniform width d1 is formed. The liquid film 70 of the pretreatment solution and the coating solution are extremely compatible with each other, thus the coating solution extends to the same annular region as the liquid film 70 of the pretreatment solution, and the coating film 80 is formed. That is to say, the width of the coating film 80 is the same as the width of the liquid film 70 of the pretreatment solution, and is uniform.

Accordingly, when the liquid film 70 of the pretreatment solution is uniformly formed with the same width d1 as the target width of the coating film 80 to be formed, the coating film 80 can be formed with the uniform target width. The liquid film 70 of the pretreatment solution and the coating solution are extremely compatible with each other, thus even when there is a factor deteriorating the uniformity described above, the coating solution extends to be blended in the liquid film 70 as long as the uniformity of the width of the liquid film 70 is maintained, and the width of the coating film 80 can also be uniformized. For example, even when vibration occurs in the second nozzle 30, the coating solution extends to melt into the liquid film 70 of the pretreatment solution as long as the width of the liquid film 70 of the pretreatment solution is uniform, thus the coating film 80 having the uniform width can be formed.

It is a necessary condition to form the liquid film 70 of the pretreatment solution with a uniform width as a premise of such a technique. It is significantly easy to form the liquid film 70 of the pretreatment solution with a uniform width compared with a case where the coating solution is directly discharged to the substrate W to form the coating film 80 with a uniform width. The reason is that it is correspondingly difficult to apply the coating solution having higher stickiness than the pretreatment solution to the peripheral edge part of the substrate W only once to form the coating film 80 with a uniform width. In contrast, it is significantly easy to form the liquid film 70 having a uniform width in the case where the pretreatment solution relatively having low stickiness reaches and recoats the peripheral edge part of the substrate W several times while the substrate W is rotated with a relatively large number of rotations of 500 times or more per minute. According to this configuration, the liquid film 70 having a uniform width can be formed even if the center of the substrate W is eccentric from the rotation axis of the spin motor 12. The first nozzle 20 discharging the pretreatment solution has a higher degree of freedom in a nozzle structure than the second nozzle 30 discharging the coating solution, and furthermore, a discharge rate can be adjusted more easily in the pretreatment solution, thus the liquid film 70 of the pretreatment solution can be formed with a uniform width more easily also in accordance with these conditions.

To be summarized, in the first embodiment, the pretreatment solution reaches and recoats the upper surface of the peripheral edge part of the substrate W several times while the substrate W is rotated with relatively a large number of rotations of 500 times or more per minute, and the liquid film 70 of the pretreatment solution having a uniform width is annularly formed. Then the coating solution is supplied on the liquid film 70, and extends to the same annular region as the liquid film 70 to form the coating film 80 having a uniform width.

### <Second embodiment>

Next, a second embodiment according to the present invention will be described. In the second embodiment, the first nozzle 20 discharging the pretreatment solution is provided on the lower side of the substrate W held by the spin chuck 11, and the pretreatment solution supplied to the lower surface of the peripheral edge part of the rotated substrate W extends from the end edge part of the substrate W to the upper surface of the peripheral edge part.

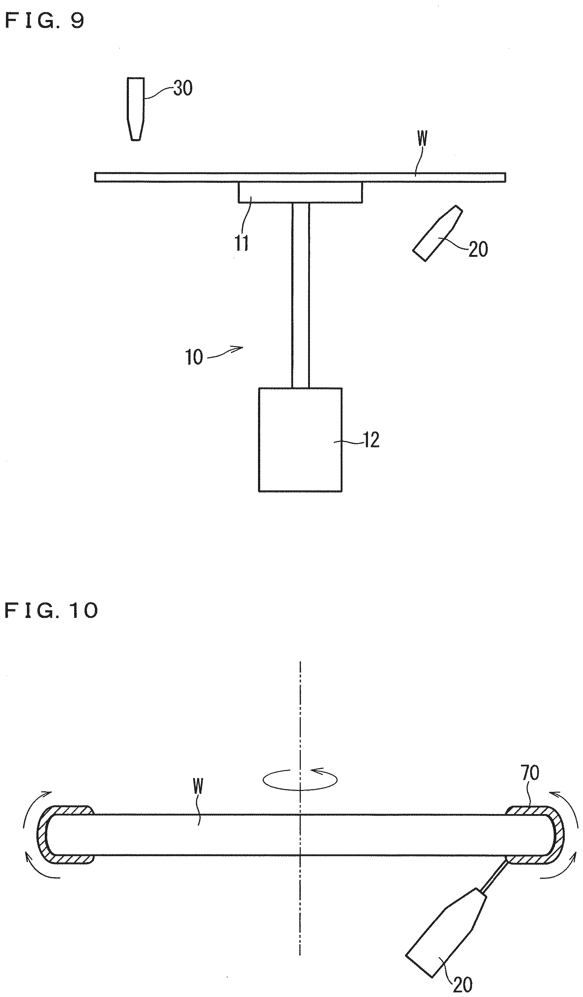

Fig. 9 is a diagram illustrating a schematic configuration of a main part of the substrate treatment apparatus according to the second embodiment. In Fig. 9, the same sign is assigned to the same element as that in the first embodiment (Fig. 1). In the first embodiment, the first nozzle 20 is provided on the upper side of the substrate W held by the spin chuck 11, however, in the second embodiment, the first nozzle 20 discharging the pretreatment solution is provided on the lower side of the substrate W. In the second embodiment, the first nozzle 20 may be disposed and fixed. The first nozzle 20 according to the second embodiment is provided to be inclined so that the discharge direction thereof is directed to the end edge part side of the substrate W. A remaining configuration of the second embodiment is similar to that of the first embodiment except for the configuration of the first nozzle 20.

The treatment procedure of the substrate W in the second embodiment is also substantially similar to that of the first embodiment (Fig. 2). That is to say, after the substrate W is held by the spin chuck 11 of the rotation holding part 10, the rotation of the substrate W is started. Then, the pretreatment solution is discharged from the first nozzle 20 provided on the lower side of the substrate W to form the liquid film 70 of the pretreatment solution on the peripheral edge part of the substrate W. In the process of forming the liquid film in Step S3, the pretreatment solution is supplied to the lower surface of the peripheral edge part of the rotated substrate W.

Fig. 10 is a diagram schematically illustrating formation of a liquid film of a pretreatment solution according to the second embodiment. The pretreatment solution supplied to the lower surface of the peripheral edge part of the rotated substrate W from the first nozzle 20 flows toward the end edge part of the substrate W by centrifugal force. Then, the pretreatment solution reaching the end edge part of the substrate W partially extends to the upper surface of the peripheral edge part from the end edge part of the substrate W by surface tension of the substrate W. As a result, the pretreatment solution covers the region having a constant slight width from the end edge part to the center part of the upper surface of the substrate W. A dimension of the width is regulated by a balance between the surface tension and centrifugal force of the substrate W. Accordingly, the liquid film 70 of the pretreatment solution having a constant width is annularly formed on the upper surface of the peripheral edge part of the substrate W in the manner similar to the first embodiment. However, the pretreatment solution partially flies away from the substrate W by centrifugal force, thus amount of liquid of the consumed pretreatment solution is larger in the second embodiment than that in the first embodiment.

Processes subsequent to Step S4 are the same as those in the first embodiment. That is to say, after the film thickness of the liquid film 70 of the pretreatment solution is adjusted, the coating solution is supplied on the liquid film 70 of the pretreatment solution to form the coating film 80. Subsequently, the coating film 80 is dried, and then the back surface of the substrate W is cleaned.

In the second embodiment, the pretreatment solution is supplied to the lower surface of the peripheral edge part of the substrate W, and the pretreatment solution extends to the upper surface of the peripheral edge part from the end edge part of the substrate W, thus the liquid film 70 of the pretreatment solution is annularly formed on the upper surface of the peripheral edge part. The width of the liquid film 70 of the pretreatment solution is regulated by a balance between the surface tension and centrifugal force of the substrate W. Accordingly, the width of the liquid film 70 of the pretreatment solution can be uniformized even when the center of the substrate W is eccentric from the rotation axis of the spin motor 12, for example. The coating solution is supplied on the liquid film 70 of the pretreatment solution formed to have a uniform width, thus the coating film 80 having a uniform width can be annularly formed in the manner similar to the first embodiment.

### <Modification example>

While the embodiments according to the present invention have been described hereinabove, various modifications of the present invention are possible in addition to those described above without departing from the scope and spirit of the present invention. For example, the liquid including PGMEA or PGME is used as the pretreatment solution in each embodiment described above, but is not limited thereto. Any solution is applicable as long as the pretreatment solution is a solution including a solvent of a coating solution or a solution reducing a contact angle of a coating solution with respect to an upper surface of the substrate. Accordingly, an appropriate solution corresponding to a type of a coating film to be formed is preferably selected as the pretreatment solution.

The resist film or the bottom layer film is formed as the coating film 80 in the embodiments described above. However, the coating film 80 is not limited thereto, but any film is applicable as long as a film has resistance to an etching treatment such as DRIE.

The coating solution is applied on the liquid film 70 on the upper surface of the peripheral edge part of the substrate W only once in each embodiment described above, however, the coating solution may be applied twice or three times.

When the center of the substrate W is eccentric from the rotation axis of the spin motor 12, the first nozzle 20 may be operated to follow the eccentricity to form the liquid film 70 of the pretreatment solution with a uniform width.

The pretreatment solution is discharged from the first nozzle 20 toward the vertically lower side in the first embodiment, however, the pretreatment solution may be alternatively discharged from the first nozzle 20 toward an obliquely lower side (toward the end edge part of the substrate W). In the similar manner, the coating solution may be discharged from the second nozzle 30 toward an obliquely lower side.

While the invention has been shown and described in detail, the foregoing description is in all aspects illustrative and not restrictive. It is therefore understood that numerous modifications and variations can be devised without departing from the scope of the invention.

## Claims

1. A substrate treatment method of forming a coating film (80) on a peripheral edge part of a disk-shaped substrate (W), comprising steps of:
(a) supplying a pretreatment solution including a solvent of a coating solution for forming the coating film to the substrate while rotating the substrate in a horizontal plane, and forming a liquid film (70) of the pretreatment solution in an annular application region having a same width as a target width in forming the coating film in an upper surface of the peripheral edge part of the substrate; and
(b) supplying the coating solution on the liquid film of the pretreatment solution while rotating the substrate in a horizontal plane, and forming the coating film.

2. A substrate treatment method of forming a coating film (80) on a peripheral edge part of a disk-shaped substrate (W), comprising steps of:
(a) supplying a pretreatment solution reducing a contact angle of a coating solution for forming the coating film with respect to an upper surface of the substrate to the substrate while rotating the substrate in a horizontal plane, and forming a liquid film (70) of the pretreatment solution in an annular application region having a same width as a target width in forming the coating film in the upper surface of the peripheral edge part of the substrate; and
(b) supplying the coating solution on the liquid film of the pretreatment solution while rotating the substrate in a horizontal plane, and forming the coating film.

3. The substrate treatment method according to claim 1 or 2, wherein
in the step (a), the pretreatment solution is supplied to a lower surface of the peripheral edge part of the substrate so that the pretreatment solution extends from an end edge part to the upper surface of the peripheral edge part of the substrate.

4. The substrate treatment method according to claim 1 or 2, wherein
in the step (a), the pretreatment solution is supplied to the upper surface of the peripheral edge part of the substrate while the substrate is rotated 500 times or more per minute to make the pretreatment solution reach and recoat the application region several times.

5. The substrate treatment method according to claim 1 or 2, wherein
the pretreatment solution is a liquid including propylene glycol monomethyl ether acetate or propylene glycol monomethyl ether.

6. A substrate treatment apparatus forming a coating film (80) on a peripheral edge part of a disk-shaped substrate (W), comprising:
a rotation holding part (10) rotating the substrate around a central axis of the substrate while holding the substrate in a horizontal posture;
a pretreatment solution discharge nozzle (20) supplying a pretreatment solution including a solvent of a coating solution for forming the coating film to the substrate which is rotated, and forming a liquid film (70) of the pretreatment solution in an annular application region having a same width as a target width in forming the coating film in an upper surface of the peripheral edge part of the substrate; and
a coating solution discharge nozzle (30) supplying the coating solution on the liquid film of the pretreatment solution formed on the upper surface of the peripheral edge part of the substrate which is rotated, and forming the coating film.

7. A substrate treatment apparatus forming a coating film (80) on a peripheral edge part of a disk-shaped substrate (W), comprising:
a rotation holding part (10) rotating the substrate around a central axis of the substrate while holding the substrate in a horizontal posture;
a pretreatment solution discharge nozzle (20) supplying a pretreatment solution reducing a contact angle of a coating solution for forming the coating film with respect to an upper surface of the substrate to the substrate which is rotated, and forming a liquid film (70) of the pretreatment solution in an annular application region having a same width as a target width in forming the coating film in the upper surface of the peripheral edge part of the substrate; and
a coating solution discharge nozzle (30) supplying the coating solution on the liquid film of the pretreatment solution formed on the upper surface of the peripheral edge part of the substrate which is rotated, and forming the coating film.

8. The substrate treatment apparatus according to claim 6 or 7, wherein
the treatment solution discharge nozzle supplies the pretreatment solution to a lower surface of the peripheral edge part of the substrate to make the treatment solution extend from an end edge part to the upper surface of the peripheral edge part of the substrate.

9. The substrate treatment apparatus according to claim 6 or 7, wherein
the treatment solution discharge nozzle supplies the pretreatment solution to the upper surface of the peripheral edge part of the substrate while the rotation holding part rotates the substrate 500 times or more per minute to make the pretreatment solution reach and recoat the application region several times.

10. The substrate treatment apparatus according to claim 6 or 7, wherein
the pretreatment solution is a liquid including propylene glycol monomethyl ether acetate or propylene glycol monomethyl ether.
